# EUROPEAN PATENT APPLICATION

(11) **EP 4 435 836 A1**
(43) Date of publication of application: **25.09.2024**
(21) Application number: 22896067.0
(22) Date of filing: 16.11.2022
(51) Int. Cl.: H01L 21/67, H05B 1/02, H05B 3/28, C04B 35/581, C04B 35/58

(54) **CERAMIC HEATER FOR SEMICONDUCTOR MANUFACTURING APPARATUS**

(30) Priority: 19.11.2021 KR 20210160465; 04.10.2022 KR 20220126575
(71) Applicant: KSM Component Co., Ltd., Haseong-myeon Gimpso-si, Gyeonggi-do 10011 (KR)
(72) Inventor: KIM, Yun Ho, Seoul 04419 (KR); KIM, Joo Hwan, Gimpo-si, Gyeonggi-do 10011 (KR); PARK, Hwan Young, Gimpo-si, Gyeonggi-do 10073 (KR); KIM, Bo Sung, Gimpo-si, Gyeonggi-do 10063 (KR)
(74) Representative: dompatent von Kreisler Selting Werner - Partnerschaft von Patent- und Rechtsanwälten mbB
(86) International application number: PCT/KR2022/018121
(87) International publication number: WO 2023/090862

(57) **Abstract**

Disclosed is a ceramic heater for a semiconductor manufacturing apparatus, the ceramic heater having volume resistivity especially at high temperature and thermal conductivity at room temperature that are superior to those of a normal ceramic heater for a semiconductor manufacturing apparatus. The ceramic heater for a semiconductor manufacturing apparatus includes a ceramic substrate including a) aluminum nitride (AIN), b) any one or more among magnesium oxide (MgO), alumina (Al₂O₃) and spinel (MgAl₂O₄), c) calcium oxide (CaO) and d) titanium dioxide (TiO₂); and a resistive heating element.

## Description

### [Technical Field]

This application claims the benefit of priorities based on Korean Patent Application Nos. 10-2021-0160465 filed on November 19, 2021 and 10-2022-0126575 filed on October 04, 2022, the entire contents of which are incorporated herein by reference.

The present invention relates to a ceramic heater used in a semiconductor manufacturing apparatus, and more particularly, to a ceramic heater for a semiconductor manufacturing apparatus that has excellent volume resistivity at high temperature and thermal conductivity at room temperature compared to the conventional ceramic heaters for a semiconductor manufacturing apparatus.

### [Background Art]

A heater for PECVD or CVD processes used in a semiconductor manufacturing apparatus includes a ceramic substrate and a resistive heating element. Among these, the ceramic substrate should have plasma resistance and high volume resistivity at low and high temperatures to improve productivity in a wafer deposition process. For this reason, aluminum nitride (AlN) has been proposed as the main components of the ceramic substrate. This aluminum nitride is stable at high temperature and has excellent physical properties such as electrical insulation and thermal conductivity. In addition, since aluminum nitride has a thermal expansion coefficient similar to silicon, it is mainly used in the semiconductor manufacturing apparatus that requires high electrical resistance at high temperature.

Meanwhile, recently, in the semiconductor process, progress is being made toward miniaturization of processes and larger diameter equipment to improve yields, but due to this miniaturization of processes and large diameter equipment, various problems occur during the semiconductor manufacturing process. Therefore, the next-generation semiconductor processing technology that can overcome those problems is needed. Accordingly, the process is carried out at 600 to 700°C which is a harsher environment, and requires ceramic properties in which the volume resistivity at 500°C is at least in the range of 5.0E+9 to 1.0E+10 Ω·cm, and the volume resistivity at 600 to 700°C is at least in the range of 1.0E+8 to 1.0E+9 Ω·cm. In addition, a typical aluminum nitride ceramic heater tends to have a rapid decrease in volume resistivity starting from 500°C, resulting in leakage current.

In this regard, Korean Patent Laid-open Publication No. 10-2006-0111279 (hereinafter referred to as Patent Document 1), Korean Patent Laid-open Publication No. 10-2006-0103146 (hereinafter referred to as Patent Document 2), and Korean Patent Laid-open Publication No. 10-2018-0126142 (hereinafter referred to as Patent Document 3) all relate to an aluminum nitride heater (AlN heater), and all of them involve sintering not only aluminum nitride and magnesium oxide but also rare earth oxides (yttrium oxide, etc.), and disclose that the volume resistivity rate of Patent Document 1 is 1.0E+15 Ω·cm or more at room temperature, the volume resistivity rate of Patent Document 2 is 1.0E+15 Ω·cm or more at 200°C, and the volume resistivity rate of Patent Document 3 exceeds 1.0E+8 Ω·cm at 400°C.

However, in all of these patent documents, the volume resistivity rate at 600 to 700°C, which is the temperature condition of recent semiconductor processes, does not even reach the range of 1.0E+8 to 1.0E+9 Ω·cm, and the volume resistivity at 500°C does not even reach the range of 5.0E+9 to 1.0E+ 10 Ω·cm. As stated in numerous papers and patent documents, this is due to material characteristics of aluminum nitride, whose volume resistivity inevitably drops at 500°C or higher. In this case, the problem of the rapid increase in leakage current also occurs. To improve this, semiconductor equipment heater manufacturers are conducting continuous research to improve volume resistivity at 500°C or higher (in particular, 600 to 700°C), but a clear solution has not yet been found.

In addition, the existing aluminum nitride ceramic heater including magnesium oxide and rare earth oxides has thermal conductivity of only about 40 to 50 W/m.k at room temperature, resulting in increased temperature uniformity deviation and reduced yield. Generally, when the deposition process is carried out at high temperature, in order to clean the chamber after the process, it is performed by a dry or wet method by lowering the temperature to an appropriate temperature (approximately 200 to 300°C). In this case, when the thermal conductivity is low, it takes cooling time to lower a cleaning temperature and time (heat up time) to raise the temperature back to the temperature required in the process after the cleaning. Also, when the thermal conductivity is low like this, more unnecessary time is required compared to other cases, so the yield is also inevitably lowered. In particular, because quality and yield are priorities for semiconductors, it is necessary to improve yield by increasing the thermal conductivity of the existing ceramic heater. In addition, when the temperature uniformity deviation of the thermal conductivity is large, the lifespan of the product may be shortened due to thermal stress and thermal shock. Therefore, there is a need for the ceramic heater that simultaneously has the thermal conductivity of 60 W/m.k or more, and preferably 80 W/m.k or more, to meet the next-generation semiconductor process.

### [Prior Art Documents]

### [Patent Documents]

(Patent Document 1) Korean Patent Laid-open Publication No. 10-2006-0111279
(Patent Document 2) Korean Patent Laid-open Publication No. 10-2006-0103146
(Patent Document 3) Korean Patent Laid-open Publication No. 10-2018-0126142

### [Disclosure]

### [Technical Problem]

Accordingly, it is an object of the present invention to provide a ceramic heater for a semiconductor manufacturing apparatus that has, in particular, excellent volume resistivity at high temperature and thermal conductivity at room temperature compared to the conventional ceramic heaters for a semiconductor manufacturing apparatus.

### [Technical Solution]

To achieve the above object, there is provided a ceramic heater for a semiconductor manufacturing apparatus, including: a ceramic substrate including a) aluminum nitride (AIN), b) at least one among magnesium oxide (MgO), alumina (Al₂O₃) and spinel (MgAl₂O₄), c) calcium oxide (CaO) and d) titanium dioxide (TiO₂); and a resistive heating element.

### [Advantageous Effects]

According to a ceramic heater for a semiconductor manufacturing apparatus according to the present invention, it has the advantage of having, in particular, excellent volume resistivity at high temperature and thermal conductivity at room temperature compared to the conventional ceramic heater for a semiconductor manufacturing apparatus.

### [Best Mode]

Hereinafter, the present invention will be described in detail.

A ceramic heater for a semiconductor manufacturing apparatus according to the present invention includes: a ceramic substrate including a) aluminum nitride (AIN), b) at least one among magnesium oxide (MgO), alumina (Al₂O₃) and spinel (MgAl₂O₄), c) calcium oxide (CaO) and d) titanium dioxide (TiO₂); and a resistive heating element.

A ceramic heater used in a semiconductor manufacturing apparatus includes a ceramic substrate and a resistive heating element. Among these, the ceramic substrate should have plasma resistance and high volume resistivity at high temperature to be able to improve the productivity of the semiconductor manufacturing apparatus including the ceramic heater. For this reason, aluminum nitride (AlN), which is stable at high temperature, has excellent physical properties such as electrical insulation and thermal conductivity, and has a thermal expansion coefficient similar to silicon, is used as main components of the substrate of the ceramic heater for a semiconductor manufacturing apparatus (as the remaining components, additives such as magnesium oxide and rare earth metal oxides may be exemplified).

However, recently, due to the miniaturization of processes and larger diameter equipment to improve yield in semiconductor processes, the next-generation semiconductor process technology is needed. In particular, since the semiconductor manufacturing process is carried out at 600 to 700°C, excellent ceramic properties, in which the volume resistivity at 500°C is at least in the range of 5.0E+9 to 1.0E+ 10 Ω·cm, and the volume resistivity at 600 to 700°C is at least in the range of 1.0E+8 to 1.0E+9 Ω·cm, are required. However, the conventional ceramic heater including aluminum nitride as the main components of the ceramic substrate has a problem in that the volume resistivity decreases rapidly starting from 500°C, resulting in leakage current. In addition, since the existing aluminum nitride ceramic heater including rare earth oxide has thermal conductivity of only about 40 to 50 W/m.k at room temperature, it is required to have thermal conductivity of 60 W/m.k or more, and preferably 80 W/m.k or more, to meet the next-generation semiconductor process.

Accordingly, as a result of repeated research from various angles, the present applicant has found that, when at least one of magnesium oxide (MgO), alumina (Al₂O₃), and spinel (MgAl₂O₄) in addition to aluminum nitride (AlN) and calcium oxide (CaO) and titanium dioxide (TiO₂) are included as a ceramic substrate component for a ceramic heater for a semiconductor manufacturing apparatus, volume resistivity is excellent even at 500°C or higher, preferably 600 to 700°C, and more preferably at about 650°C, and thermal conductivity at room temperature is also excellent as 80 W/m.k or more.

More specifically, the aluminum nitride included in the ceramic substrate of the ceramic heater for a semiconductor manufacturing apparatus according to the present invention is included in the remaining amount excluding the total content of the remaining components, that is, at least one of magnesium oxide (MgO), alumina (Al₂O₃), and spinel (MgAl₂O₄); calcium oxide (CaO); and titanium dioxide (TiO₂). Specifically, the aluminum nitride may be included in 75 to 98wt%.

The magnesium oxide may be included to improve the thermal conductivity and volume resistivity of the ceramic heater. The magnesium oxide is used to form a MgAl₂O₄ spinel ceramic (or spinel) phase through an organic combination (sintering, especially sintering with alumina) with the aluminum nitride and alumina to be described later. The content of the magnesium oxide may be 0.1 to 10wt%, preferably 0.1 to 5wt%, and more preferably 1 to 4wt%. There is a risk that, when the content of the magnesium oxide is less than 0.1wt%, the MgAl₂O₄ spinel phase formed by sintering aluminum nitride and magnesium oxide and sintering alumina and magnesium oxide is hardly formed, so the effect may be insignificant or absent, and when the content of the magnesium oxide exceeds 10wt%, the density after the sintering decreases, so the thermal conductivity decreases.

Meanwhile, it is preferable that the aluminum nitride is composed only of micrometer-sized particles. In addition, the magnesium oxide may be composed only of particles with an average size of nanometers (tens to hundreds of nanometers), composed only of particles with an average size of micrometers (several micrometers), or composed of a mixture of nanometer-sized particles and micrometer-sized particles. However, it may be preferable that the magnesium oxide is composed only of nanometer-sized particles or only micrometer-sized particles rather than a mixture of nanometer-sized particles and micrometer-sized particles, and it may be more preferable that the magnesium oxide is composed only of nanometer-sized particles to have better sinterability, volume resistivity, and thermal conductivity.

That is, the aluminum nitride constituting the ceramic heater of the present invention, more precisely the ceramic substrate, is included as micro-sized particles, and the magnesium oxide may be included as nano-sized particles, micro-sized particles, or nano/micro-sized particles. In this case, the magnesium oxide may be preferably included as nano-sized particles or micro-sized particles, and may be more preferably included as nano-sized particles. When the powder particles of the aluminum nitride and magnesium oxide do not have micro-nano, micro-micro, and micro-nano/micro sizes, the physical properties such as the volume resistivity and thermal conductivity of the ceramic heater required by the next-generation semiconductor process may not be satisfied. In addition, the average particle diameter of the aluminum nitride particles may be preferably 0.9 to 1.4 µm. In addition, when the size of the magnesium oxide particles is nanometer scale, the average particle diameter may be preferably 50 to 100 nm, and when the size of the magnesium oxide particles is micrometer scale, the average particle diameter may be preferably 3 to 5 µm.

Next, the alumina included in the ceramic substrate of the present invention may be used to form the MgAl₂O₄ spinel phase through the sintering with the magnesium oxide. The content of the magnesium oxide may be 0.05 to 5wt%, preferably 0.05 to 3.5wt%, and more preferably 0.5 to 2wt%. When the content of the alumina is less than 0.05wt%, the MgAl₂O₄ spinel phase formed by sintering with the magnesium oxide is hardly formed, so the effect may be insignificant or absent, and when the content of the alumina exceeds 5wt%, a problem may occur that the thermal conductivity greatly decreases.

Meanwhile, in the present invention, instead of including the magnesium oxide (MgO) and alumina (Al₂O₃) in the ceramic substrate of the ceramic heater for a semiconductor manufacturing apparatus, the spinel (MgAl₂O₄) may be included alone. That is, since the main purpose of using the magnesium oxide and alumina in the present invention is to form the MgAl₂O₄ spinel phase, it is also possible to include spinel (MgAl₂O₄) as a raw material from the time of the initial manufacturing. In addition, for the purpose of generating an independent effect by one or more of the magnesium oxide and alumina, the spinel (MgAl₂O₄) is basically included, but it is also possible to include one or more of the magnesium oxide and alumina together.

In addition, when the spinel (MgAl₂O₄) is included alone without the magnesium oxide and alumina, the content of the spinel (MgAl₂O₄) may be 1 to 12wt%, preferably 3 to 10wt%, and more preferably 5 to 10wt%. There is a risk that, when the content of the spinel (MgAl₂O₄) is less than 1wt%, there is not enough spinel phase, so the required volume resistivity may not be obtained, and when the content of the spinel (MgAl₂O₄) exceeds 12wt%, the spinel phase with relatively low thermal conductivity increases, so the overall thermal conductivity may decrease.

In addition, even when the spinel (MgAl₂O₄) is included together with any one or more of the magnesium oxide and alumina, the spinel (MgAl₂O₄) may be included in the same content as above. However, since the MgAl₂O₄ spinel phase is also formed through the sintering between the aluminum nitride and the magnesium oxide and the sintering between the alumina and the magnesium oxide, it may be preferable for the spinel MgAl₂O₄ to be included so that the content of the spinel (MgAl₂O₄) in the finally manufactured ceramic substrate does not exceed 12wt%. That is, when the spinel (MgAl₂O₄) is included together with at least one of the magnesium oxide and alumina, it may be preferable that the total weight of the MgAl₂O₄ spinel phase produced through the sintering between the aluminum nitride and the magnesium oxide and the sintering between the alumina and the magnesium oxide plus the content of the spinel (MgAl₂O₄) included alone does not exceed 12wt%.

In addition, even when the magnesium oxide and alumina are included without the spinel (MgAl₂O₄) from the time of the initial manufacturing, the content of the spinel (MgAl₂O₄) in the finally manufactured ceramic substrate is preferably 1 to 12wt% as above. In this case, when the content of magnesium oxide relative to the alumina is excessively included beyond a stoichiometric ratio, the magnesium oxide remaining without reacting with the alumina may additionally form the MgAl₂O₄ spinel phase through the reaction with the alumina produced by reacting a portion of the aluminum nitride with oxygen during the high-temperature sintering process. Even in this case, it is preferable that the content of spinel (MgAl₂O₄) in the ceramic substrate is the same as above.

Subsequently, the calcium oxide included in the ceramic substrate of the present invention is used to maximize the volume resistivity rate and thermal conductivity of the ceramic heater. The content of the calcium oxide may be 0.01 to 4wt%, and preferably 0.1 to 3wt%. When the content of the calcium oxide is less than 0.01wt%, it is difficult to maximize the volume resistivity rate and thermal conductivity of the ceramic heater according to the present invention, and when the content of the calcium oxide exceeds 4wt%, there may be no further advantage in maximizing the volume resistivity rate and thermal conductivity of the ceramic heater according to the present invention.

The titanium dioxide included in the ceramic substrate of the present invention is also used to maximize the volume resistivity rate and thermal conductivity of the ceramic heater according to the present invention. The content of the titanium dioxide may be 0.01 to 7wt%, and preferably 0.1 to 5wt%. When the content of the titanium dioxide is less than 0.01wt%, it is difficult to maximize the volume resistivity rate and thermal conductivity of the ceramic heater according to the present invention, and when the content of the titanium dioxide exceeds 7wt%, there may be no further advantage in maximizing the volume resistivity rate and thermal conductivity of the ceramic heater according to the present invention.

The aluminum nitride (AlN); at least one of the magnesium oxide (MgO), alumina (Al₂O₃), and the spinel (MgAl₂O₄); the calcium oxide (CaO); and the titanium dioxide (TiO₂) described above are preferably included in the ceramic substrate in the sintered form. In this case, the ceramic substrate includes the MgAl₂O₄ spinel phase (formed through at least one of the sintering between the aluminum nitride and the magnesium oxide and the sintering between the alumina and the magnesium oxide, or formed by the separately added spinel (MgAl₂O₄) itself), and when the alumina is used, also includes an AlON phase formed through the sintering between the aluminum nitride and the alumina.

Therefore, the ceramic substrate basically includes the MgAl₂O₄ spinel phase, but may also include the AlON phase. In addition, when the MgAl₂O₄ spinel phase and the AlON phase are included together, the MgAl₂O₄ spinel phase and the AlON phase may be preferably included in the ceramic substrate at a weight ratio of 7 to 10: 1 (in this case, the AlON phase may be included in 0.1 to 2wt%). When the weight ratio of the MgAl₂O₄ spinel phase and the AlON phase included in the ceramic substrate is outside the above range, a problem may occur that the volume resistivity at high temperature decreases or the thermal conductivity at high temperature decreases. Meanwhile, the ceramic substrate may include raw materials such as the aluminum nitride in addition to the MgAl₂O₄ spinel phase and AlON phase.

The ceramic heater for a semiconductor manufacturing apparatus (more precisely, a ceramic substrate or ceramic sintered body) according to the present invention as described above has a volume resistivity rate of 1.0E+10 to 9.0E+10 Ω·cm at 500°C, a volume resistivity rate of 1.0E+9 to 8.0E+9 Ω·cm at 650°C, and thermal conductivity of 80 W/m.k or more, and preferably 80 to 90 W/m.k at room temperature. That is, the purpose of the present invention may be achieved only when the ceramic heater simultaneously satisfies the volume resistivity rate at 500°C, the volume resistivity rate at 650°C, and the thermal conductivity at room temperature. In addition, the ceramic heater of the present invention has the amount of leakage current of less than 0.05 µA, and preferably 0.01 to 0.035 µA.

When the volume resistivity rate is not satisfied, it is difficult to apply the ceramic heater to the next-generation semiconductor manufacturing process, and even if applied, the leakage current may rapidly increase, resulting in the breakage of the wafer. In addition, when the above thermal conductivity is not satisfied, problems such as increased temperature uniformity deviation and reduced yield may occur. Generally, when the deposition process is carried out at high temperature, in order to clean the chamber after the process, it is performed by a dry or wet method by lowering the temperature to an appropriate temperature (approximately 200 to 300°C). In this case, when the thermal conductivity is low, since a lot of unnecessary time is required, such as cooling time to lower the cleaning temperature and heat up time to raise the temperature to the required temperature in the process after the cleaning, the yield is also bound to decrease. In addition, when the temperature uniformity deviation of the thermal conductivity is large, the lifespan of the product may be shortened due to thermal stress and thermal shock.

Meanwhile, the ceramic substrate of the present invention may further include one or more additives selected from the group consisting of titanium nitride (TiN); tungsten carbide (WC); carbon nanotubes (CNT); nitrogen boride (BN); silicon dioxide (SiO₂); graphene; and oxides of one or more rare earth metals selected from the group consisting of scandium (Sc), yttrium (Y), lanthanum (La), cerium (Ce), praseodymium (Pr), neodymium (Nd), promethium (Pm), samarium (Sm), europium (Eu), and gadolinium (Gd), terbium (Tb), dysprosium (Dy), holmium (Ho), erbium (Er), thulium (Tm), ytterbium (YB), and lutetium (Lu), if necessary, in addition to aluminum nitride (AlN); at least one of magnesium oxide (MgO), alumina (Al₂O₃), and spinel (MgAl₂O₄); calcium oxide (CaO); and titanium dioxide (TiO₂) described above. In addition, the ceramic substrate of the present invention does not include manganese oxide such as MnO. This is because when the manganese oxide is included in the ceramic substrate, the problems such as the rapid decrease in volume resistivity rate occur.

The rare earth metal oxides may be advantageous in improving the thermal conductivity of the ceramic heater, and may include one rare earth metal or two to five different rare earth metals. Examples of the rare earth metal oxide including 2 to 5 different rare earth metals may include complex oxides including two different rare earth metals, such as europium-gadolinium complex oxide (EuGdOx), samarium-gadolinium complex oxide (SmGdOx), cerium-europium complex oxide (CeEuOx), samarium-cerium complex oxide (SmCeOx), gadolinium-samarium complex oxide (GdSmOx), and lanthanum-cerium complex oxide (LaCeOx); complex oxides including three different rare earth metals, such as samarium-cerium-europium complex oxide (SmCeEuOx), gadolinium-cerium-lanthanum complex oxide (GdCeLaOx), and europium-gadolinium-samarium complex oxide (EuGdSmOx); complex oxides including four different rare earth metals, such as samarium-cerium-gadolinium-europium complex oxide (SmCeGdEuOx) and gadolinium-samarium-europium-lanthanum complex oxide (GdSmEuLaOx); and complex oxides including five different rare earth metals, such as samarium-cerium-europium-gadolinium-lanthanum complex oxide (SmCeEuGdLaOx), and the rare earth metal oxides may be used without particular restrictions as long as it includes 2 to 5 different rare earth metals (oxides).

The rare earth metal oxide including the 2 to 5 different rare earth metals may include various types of rare earth metals in various mixing ratios. For example, the rare earth metal oxide including 2 to 5 different rare earth metals may include two types of rare earth metals (oxides) in a weight ratio of 2.5 to 3.5:1, or three types of rare earth metals (oxides) in a weight ratio of 1 to 3.5:0.5 to 2.5:1, or four types of rare earth metals (oxides) in a weight ratio of 1.5 to 3.5:0.5 to 2.5:1 to 2.5:1, or five types of rare earth metals (oxides) in a weight ratio of 1 to 3:0.5 to 1.5:0.5 to 1.5:1 to 2:1, etc., and the rare earth metals (oxides) may be appropriately mixed to maximize the targeted effects of the rare earth metal oxides. More specifically, SmCeEuOx may include each rare earth metal (oxide) in a weight ratio of 2:1:1, GdCeLaOx may include each rare earth metal (oxide) in a weight ratio of 3:2:1, EuGdSmOx may include each rare earth metal (oxide) in a weight ratio of 1.5:1.5:1, SmCeGdEuOx may include each rare earth metal (oxide) in a weight ratio of 2:1:1.5:1, and GdSmEuLaOx may include each rare earth metal (oxide) in a weight ratio of 3:2:2:1, SmCeEuGdLaOx may include each rare earth metal (oxide) in a weight ratio of 2:1:1:1.5:1.

When the rare earth metal oxide includes two or more different types of rare earth metals (oxides), any one rare earth metal may be dissolved in solid solution in the remaining one (or any one) rare earth metal oxide. Through this, the crystal of the rare earth metal oxide changes, and therefore, the oxygen lattice defects of the rare earth composite oxide may increase compared to the single rare earth metal oxide. In this way, the rare earth composite oxide with the increased oxygen lattice defects has improved interfacial reactivity, and as a result, may effectively react with the raw material components included in the ceramic substrate or the interface or lattice oxygen of the sintered body.

In addition, a method of manufacturing a ceramic heater for a semiconductor manufacturing apparatus according to the present invention will be described. The method of manufacturing a ceramic heater for a semiconductor manufacturing apparatus includes a) mixing aluminum nitride, 'at least one of magnesium oxide, alumina, and spinel', calcium oxide, titanium dioxide, an alcohol compound, and a binder, b) drying the mixture to prepare a powder from which an alcohol compound component is removed, c) preparing a preform processed into a certain shape by compressing and molding (first molding) the dried powder, d) degreasing the prepared preform to remove the binder component, and e) sintering (second molding) and polishing the degreased preform to manufacture a ceramic substrate.

The spinel in the step a) may be prepared by mixing and heat-treating magnesium oxide and alumina in a ball mill. In addition, the spinel may be used alone without the magnesium oxide and alumina, or may be used together with at least one of a trace amount of magnesium oxide and alumina. The step a) is a step of mixing components constituting the ceramic substrate, in which the components may be mixed with an alcohol compound (for example, an alcohol compound having 1 to 5 carbon atoms) and a binder. In this case, purities of each of the components (in particular, aluminum nitride, magnesium oxide, and alumina) constituting the ceramic substrate is preferably 99% or more. In addition, the alcohol compound used in the step a) is used to properly mix the components constituting the ceramic substrate, and examples thereof may include ethanol, methanol, isopropyl alcohol, etc. Likewise, the binder used in the step a) is for preparing a molded body by improving the bonding strength of the components constituting the ceramic substrate, and examples thereof may include polyvinyl alcohol (PVA), polyvinyl butyral (PVB), etc.

The step b) is a step of drying the powder mixture mixed in the step a) to remove the alcohol component. The drying may be performed by the methods known in the art, such as spray drying and vacuum drying, and the drying time may be applied in various ways depending on the physical properties of the targeted ceramic heater.

The step c) is a step of compressing and molding the dried powder to prepare a preform processed into a certain shape. The compression molding is a 1^{st} molding (i.e., first molding) process for controlling the powder dried in the step b) into the targeted size and shape, and examples thereof may include press molding, etc. In this case, in order to manufacture products with more precise specifications, cold isostatic pressing (CIP) may be additionally performed as needed. The press molding is preferably performed at room temperature and in a general atmosphere, but is not limited thereto, and the atmosphere during molding may be sufficient as long as it does not affect the molding of the mixture. In addition, after the molding process in the step c) is performed, the preform may be prepared by processing such as a green processing (performed before sintering, also called raw processing) method.

The step d) is a step of removing the binder component by degreasing the prepared preform. The degreasing is a process for removing the binder and contaminants having oily properties, and may be performed within 60 hours at a temperature of 350 to 600°C.

The step e) is a step of manufacturing a ceramic substrate by sintering (second molding) and polishing the degreased preform. The sintering is a 2^{nd} forming (i.e., second forming) process (hot press) to further improve the volume resistivity rate of the ceramic heater, and may be performed in a high-temperature and pressurized sintering furnace under a pressure of 300 bar or less and a temperature of 1,300 to 1,900°C. In this case, the MgAl₂O₄ spinel phase and the AlON phase may be formed through the sintering, and therefore, the MgAl₂O₄, AlON, residual aluminum nitride, etc., may exist in the ceramic substrate formed by the sintering.

Meanwhile, the resistive heating element may be provided on any one or more of the interior and surface of the preform in the step c), or the resistive heating element may be provided on the surface of the ceramic substrate manufactured in the step e). The technologies known in the art are applied to the resistive heating element.

Hereinafter, the present invention will be described in more detail with reference to detailed Examples. The following examples are intended to illustrate the present invention, but the present invention is not limited to the following examples.

### [Examples 1 to 6, Comparative Examples 1 to 10] Manufacturing of ceramic heater

Raw materials such as aluminum nitride were mixed according to compositions in Table 1 below, and a trace amount of ethanol and polyvinyl butyral (binder) were additionally mixed and dried. Subsequently, the dried mixture was press molded and processed to prepare a preform. Then, after the preform was degreased at a temperature of 500°C for 30 hours, the degreased preform was sintered in a high-temperature pressurized sintering furnace (pressure of 250 bar, temperature of 1,700°C) and polished to manufacture a ceramic substrate. Finally, an aluminum nitride ceramic heater was manufactured by providing a resistive heating element on a surface of the manufactured ceramic substrate. Meanwhile, as spinel (MgAl₂O₄) used as a raw material in some examples and comparative examples, those prepared by mixing and heat-treating magnesium oxide and alumina using a ball mill were used.

**[Table 1]**

| | AlN | MgO | Al₂O₃ | MgAl₂O₄ | CaO | TiO₂ | Y₂O₃ | MnO |
|---|---|---|---|---|---|---|---|---|
| Example 1 | 96.8 | 2 | 1 | - | 0.1 | 0.1 | - | - |
| Example 2 | 96.7 | 2 | 1 | - | 0.1 | 0.1 | 0.1 | - |
| Example 3 | 86 | 4 | 2 | - | 3 | 5 | - | - |
| Example 4 | 92.9 | 1 | 0.5 | 5 | 0.3 | 0.3 | - | - |
| Example 5 | 88.2 | 2 | 1 | 7 | 0.5 | 1 | 0.3 | - |
| Example 6 | 89.4 | - | - | 10 | 0.3 | 0.3 | - | - |
| Comparative Example 1 | 99.49 | 0.01 | - | - | - | - | 0.5 | - |
| Comparative Example 2 | 99.95 | 0.05 | - | - | - | - | - | - |
| Comparative Example 3 | 99.45 | 0.05 | 0.1 | - | 0.2 | 0.2 | - | - |
| Comparative Example 4 | 84.5 | 4 | 10 | - | 0.5 | 1 | - | - |
| Comparative Example 5 | 59.8 | 12 | 28 | - | 0.1 | 0.1 | - | - |
| Comparative Example 6 | 96.1 | 2 | 1 | - | 0.2 | 0.2 | - | 0.5 |
| Comparative Example 7 | 88.8 | 4 | 2 | - | 0.1 | 0.1 | - | 5 |
| Comparative Example 8 | 92.8 | 1 | 0.5 | 5 | 0.1 | 0.1 | - | 0.5 |
| Comparative Example 9 | 84.8 | 2 | 1 | 7 | 0.1 | 0.1 | - | 5 |
| Comparative Example 10 | 87 | 3 | 1.5 | 5 | 0.2 | 0.2 | 0.1 | 3 |

| | | | | | | | | |
|---|---|---|---|---|---|---|---|---|
| * Unit: wt% | | | | | | | | |

### [Experimental Example 1] Evaluation of volume resistivity and thermal conductivity of ceramic heater

After applying a voltage of 500 V/mm to each ceramic heater manufactured from Examples 1 to 6 and Comparative Examples 1 to 10, a current was measured after 1 minute (measured in a vacuum atmosphere and at room temperature) to calculate a volume resistivity rate, and the results were shown in Table 2 below.

In addition, for each ceramic heater manufactured from Examples 1 to 6 and Comparative Examples 1 to 10 above, specimens were manufactured in accordance with the standards of ASTM C0408-88R11 using LFA 467 equipment from NETZSCH company, and then measured at room temperature to calculate thermal conductivity, and the results were also shown in Table 2 below.

In addition, density values of each ceramic heater manufactured in Examples 1 to 6 and Comparative Examples 1 to 10 were calculated using the Archimedes method, and the results were also shown in Table 2 below.

**[Table 2]**

| | Volume resistivity rate (Ω·cm) | | thermal conductivity (W/m.k, @ normal temperature) | Density (g/cm³) |
|---|---|---|---|---|
| | @ 500°C | @ 650°C | | |
| Example 1 | 1.7E+10 | 3.3E+09 | 85 | 3.305 |
| Example 2 | 2.1E+10 | 2.8E+09 | 86 | 3.311 |
| Example 3 | 1.2E+10 | 1.8E+09 | 83 | 3.282 |
| Example 4 | 1.9E+10 | 4.0E+09 | 82 | 3.314 |
| Example 5 | 2.1E+10 | 3.2E+09 | 83 | 3.296 |
| Example 6 | 3.3E+10 | 3.4E+09 | 80 | 3.289 |
| Comparative Example 1 | 8.0E+07 | No measurement | 82 | 3.324 |
| Comparative Example 2 | 7.8E+07 | No measurement | 78 | 3.322 |
| Comparative Example 3 | 9.1E+07 | No measurement | 83 | 3.319 |
| Comparative Example 4 | 8.8E+09 | 5.7E+08 | 58 | 3.272 |
| Comparative Example 5 | 9.8E+09 | 2.7E+09 | 24 | 3.402 |
| Comparative Example 6 | 3.4E+08 | 2.7E+07 | 62 | 3.308 |
| Comparative Example 7 | 8.1E+08 | 4.2E+07 | 55 | 3.311 |
| Comparative Example 8 | 1.2E+09 | 3.0E+07 | 61 | 3.299 |
| Comparative Example 9 | 5.5E+08 | 4.1E+07 | 52 | 3.314 |
| Comparative Example 10 | 3.2E+09 | 2.8E+08 | 58 | 3.307 |

As a result of measuring the volume resistivity rates, the thermal conductivities, and the densities of each ceramic heater manufactured in Examples 1 to 6 and Comparative Examples 1 to 10, as shown in Table 2 above, all the ceramic heaters of Examples 1 to 6 exceeded minimum volume resistivity (5.0E+9 Ω·cm to 1.0E+ 10 Ω·cm) at 500°C, minimum volume resistivity (1.0E+8 Ω·cm to 1.0E+9 Ω·cm) at 600 to 700°C, and thermal conductivity (60 W/m.k or more, preferably 80 W/m.k or more) at room temperature, which are required for the next-generation semiconductor manufacturing process.

In the case of Comparative Examples 1 and 2, not only were calcium oxide and titanium dioxide not used, but the content of the components (AlN, MgO) used was also outside the scope of the present invention, resulting in low volume resistivity rate or making the measurement impossible.

In the case of Comparative Examples 3 to 5, although all of the components constituting the ceramic substrate of the present invention are included, the content of any one or more of magnesium oxide, alumina, and aluminum nitride is outside the scope of the present invention, resulting in the low volume resistivity or low thermal conductivity.

In the case of Comparative Examples 6 to 10, all of the components constituting the ceramic substrate of the present invention are included and the content of the components is also within the scope of the present invention, but include manganese oxide, resulting in the low volume resistivity or low thermal conductivity.

Therefore, it can be seen that, only when the ceramic substrate includes aluminum nitride (AlN); any one or more of magnesium oxide (MgO), alumina (Al₂O₃), and spinel (MgAl₂O₄); calcium oxide (CaO); and titanium dioxide (TiO₂) in appropriate amounts, and should not include manganese oxide, the volume resistivity rate and thermal conductivity targeted by the present invention can be achieved simultaneously.

## Claims

1. A ceramic heater for a semiconductor manufacturing apparatus, comprising:
a ceramic substrate including
a) aluminum nitride (AIN),
b) any one or more among magnesium oxide (MgO), alumina (Al₂O₃) and spinel (MgAl₂O₄),
c) calcium oxide (CaO), and
d) titanium dioxide (TiO₂); and
a resistive heating element.

2. The ceramic heater of claim 1, wherein the ceramic substrate includes aluminum nitride, magnesium oxide, alumina, calcium oxide, and titanium dioxide.

3. The ceramic heater of claim 1, wherein the ceramic substrate includes aluminum nitride, spinel, calcium oxide, and titanium dioxide.

4. The ceramic heater of claim 1, wherein the ceramic substrate includes aluminum nitride, magnesium oxide, alumina, spinel, calcium oxide, and titanium dioxide.

5. The ceramic heater of claim 1, wherein the ceramic heater has a volume resistivity rate of 1.0E+10 to 9.0E+10 Ω·cm at 500°C.

6. The ceramic heater of claim 1, wherein the ceramic heater has a volume resistivity rate of 1.0E+9 to 8.0E+9 Ω·cm at 650°C.

7. The ceramic heater of claim 2, wherein the ceramic substrate includes 0.1 to 10wt% of magnesium oxide, 0.05 to 5wt% of alumina, 0.01 to 4wt% of calcium oxide, 0.01 to 7wt% of titanium dioxide, and the remaining aluminum nitride.

8. The ceramic heater of claim 3, wherein the ceramic substrate includes 1 to 12wt% of spinel, 0.01 to 4wt% of calcium oxide, 0.01 to 7wt% of titanium dioxide, and the remaining aluminum nitride.

9. The ceramic heater of claim 4, wherein the ceramic substrate includes 0.1 to 10wt% of magnesium oxide, 0.05 to 5wt% of alumina, 1 to 12wt% of spinel, 0.01 to 4wt% of calcium oxide, 0.01 to 7wt% of titanium dioxide, and the remaining aluminum nitride.

10. The ceramic heater of claim 1, wherein the components a) to d) are included in a ceramic substrate in a sintered form, and the ceramic substrate includes a MgAl₂O₄ spinel phase and an AlON phase.

11. The ceramic heater of claim 10, wherein the MgAl₂O₄ spinel phase and AlON phase are included in the ceramic substrate at a weight ratio of 7 to 10:1.

12. The ceramic heater of claim 1, wherein the ceramic heater has a thermal conductivity of 80 W/m.k or more at room temperature.

13. The ceramic heater of claim 1, wherein the ceramic substrate does not include manganese oxide.

14. The ceramic heater of claim 1, wherein the ceramic substrate further includes one or more additives selected from the group consisting of titanium nitride (TiN); tungsten carbide (WC); carbon nanotubes (CNT); nitrogen boride (BN); silicon dioxide (SiO₂); graphene; and oxides of one or more rare earth metals selected from the group consisting of scandium (Sc), yttrium (Y), lanthanum (La), cerium (Ce), praseodymium (Pr), neodymium (Nd), promethium (Pm), samarium (Sm), europium (Eu), and gadolinium (Gd), terbium (Tb), dysprosium (Dy), holmium (Ho), erbium (Er), thulium (Tm), ytterbium (YB), and lutetium (Lu).
